# EUROPÄISCHE PATENTSCHRIFT

(11) **EP 2 948 991 B1**
(45) Veröffentlichungstag und Bekanntmachung des Hinweises auf die Patenterteilung: **01.05.2019**
(21) Anmeldenummer: 14704656.9
(22) Anmeldetag: 08.01.2014
(51) Int. Cl.: H01L 41/107, H05H 1/24, H01L 41/312, H01L 41/053

(54) **VORRICHTUNG ZUR ERZEUGUNG EINES PLASMAS UND HANDGERÄT MIT DER VORRICHTUNG**
DEVICE FOR CREATING A PLASMA AND HANDHELD APPARATUS USING THIS DEVICE
DISPOSITIF POUR LA CRÉATION D'UN PLASMA ET APPAREIL À MAIN UTILISANT CE DISPOSITIF

(30) Priorität: 22.01.2013 DE 102013100617
(43) Veröffentlichungstag der Anmeldung: 02.12.2015
(73) Patentinhaber: Relyon Plasma GmbH, 93055 Regensburg (DE); Epcos AG, 81671 München (DE)
(72) Erfinder: NETTESHEIM, Stefan, 93051 Regensburg (DE); KORZEC, Dariusz, 93173 Wenzenbach (DE); BURGER, Dominik, 93087 Alteglofsheim (DE); KÜGERL, Georg, 8552 Eibiswald (AT); PUFF, Markus, 8010 Graz (AT); HOPPENTHALLER, Florian, 93047 Regensburg (DE)
(74) Vertreter: Reichert & Lindner Partnerschaft Patentanwälte
(86) Internationale Anmeldenummer: PCT/IB2014/058115
(87) Internationale Veröffentlichungsnummer: WO 2014/115050

(56) Entgegenhaltungen:
- EP-A1- 1 814 168
- DE-A1-102009 038 563
- DE-U1-202008 008 980
- NADAL C ET AL: "First Approach for the Modelling of the Electric Field Surrounding a Piezoelectric Transformer in View of Plasma Generation", IEEE TRANSACTIONS ON MAGNETICS, IEEE SERVICE CENTER, NEW YORK, NY, US, Bd. 48, Nr. 2, 2. Februar 2012 (2012-02-02), Seiten 423-426, XP011398344, ISSN: 0018-9464, DOI: 10.1109/TMAG.2011.2174970
- TERANISHI K ET AL: "A novel generation method of dielectric barrier discharge and ozone production using a piezoelectric transformer", JAPANESE JOURNAL OF APPLIED PHYSICS PART.2, THE JAPAN SOCIETY OF APPLIED PHYSICS, JAPAN SOCIETY OF APPLIED PHYSICS, TOKYO; JP, Bd. 43, Nr. 9B, 2. September 2004 (2004-09-02), Seiten 6733-6739, XP002432140, ISSN: 0021-4922, DOI: 10.1143/JJAP.43.6733
- TESCHKE M., ENGEMANN J.: "Low voltage APP-generation by piezo ceramics: A new revolutionary enabling technology", 18TH INTERNAT. SYMPOSIUM ON PLASMA CHEMISTRY (ISPC), 27A-A4, 26. August 2007 (2007-08-26), - 31. August 2007 (2007-08-31), XP7922582, Kyoto, Japan
- KIM HYUN ET AL: "Atmospheric pressure argon plasma jet using a cylindrical piezoelectric transformer", APPLIED PHYSICS LETTERS, AMERICAN INSTITUTE OF PHYSICS, US, Bd. 95, Nr. 21, 24. November 2009 (2009-11-24), Seiten 211501-211501, XP012126559, ISSN: 0003-6951, DOI: 10.1063/1.3267142
- RAJASEKARAN P., BIBINOV N., AWAKOWICZ P.: "Atmospheric-pressure piezo-driven microplasma source for bio-medical applications", INSTITUTE FOR ELECTRICAL ENGINEERING AND PLASMA TECHNOLOGY, 13. April 2011 (2011-04-13), XP7922580, Bochum
- ITOH H ET AL: "Discharge plasmas generated by piezoelectric transformers and their applications; Discharge plasmas generated by piezoelectric transformers", PLASMA SOURCES SCIENCE AND TECHNOLOGY, INSTITUTE OF PHYSICS PUBLISHING, BRISTOL, GB, Bd. 15, Nr. 2, 2. Mai 2006 (2006-05-02), Seiten S51-S61, XP020105199, ISSN: 0963-0252, DOI: 10.1088/0963-0252/15/2/S07
- CLEMENT NADAL ET AL: "Analytical modeling of electrical potential repartition on piezoelectric transformer", FREQUENCY CONTROL SYMPOSIUM (FCS), 2010 IEEE INTERNATIONAL, IEEE, PISCATAWAY, NJ, USA, 2. Juni 2010 (2010-06-02), Seiten 602-607, XP031738445, ISBN: 978-1-4244-6399-2

## Beschreibung

Die Erfindung betrifft eine Vorrichtung zur Erzeugung eines Plasmas. Im Besonderen ist hierzu eine Steuerschaltung vorgesehen, die zur Anregung eines piezoelektrischen Transformators mit diesem elektrisch verbunden ist.

Ferner betrifft die Erfindung ein Handgerät zur Plasmabehandlung von Oberflächen. Das Handgerät weist ein Gehäuse und eine Spannungsquelle auf.

Aus der deutschen Patentschrift DE 10 2008 018 827 B4 ist eine Vorrichtung zur Erzeugung eines Plasmas mit einem Piezoelement offenbart. Das Piezoelement ist mit einem Primär- und Sekundärbereich ausgestattet. Dabei erfolgt die Ansteuerung des Primärbereichs des Piezoelementes mit Niederspannung und Hochfrequenz. In der Folge wird das Plasma durch die Feldüberhöhung auf der Fläche des Sekundärbereichs des Piezoelements gezündet. Erfindungsgemäß erfolgt die Plasmaführung durch eine auf Erdpotential liegende Gegenelektrode und eine Gasströmung, die am Piezoelement vorbeistreicht. Durch die Gasströmung tritt das Plasma aus der Vorrichtung aus.

Die deutsche Offenlegungsschrift DE 10 2011 006 764 A1 offenbart einen Piezotransformator mit einem eingangsseitigen piezoelektrischen Wandler, einem ausgangsseitigen piezoelektrischen Wandler mit mindestens zwei Phasen, mindestens einer ersten elektrisch nicht leitenden Schicht, welche zwischen dem eingangsseitigen piezoelektrischen Wandler und dem ausgangsseitigen piezoelektrischen Wandler angeordnet ist und welche den eingangsseitigen piezoelektrischen Wandler und den ausgangsseitigen piezoelektrischen Wandler mechanisch miteinander koppelt. Ferner ist mindestens eine zweite elektrisch nicht leitende Schicht zwischen den Phasen des ausgangsseitigen piezoelektrischen Wandlers angeordnet.

Das US-Patent US 5,834,882 beschreibt den Aufbau eines piezoelektrischen Vielschicht-Transformators. Ein erstes elektroaktives Element ist mechanisch an dem zweiten elektroaktiven Element durch eine Verbindungsschicht, die zwischen einer ersten Hauptfläche des ersten elektroaktiven Elements und einer ersten Hauptfläche des zweiten elektroaktiven Elements angeordnet ist, verbunden. Die Verbindungsschicht weist eine Vorspanneinrichtung auf, um eine Druckspannung in Längsrichtung auf das erste und das zweite elektroaktive Element aufzubringen.

Die deutsche Offenlegungsschrift DE 10 2009 023 505 A1 offenbart eine Schaltungsanordnung für einen Piezotransformator und ein Verfahren zum Ansteuern eines Piezotransformators. Die Schaltungsanordnung umfasst einen Treiberschaltkreis, einen Stromsensor, eine Steuereinheit und einen Oszillator. Weiter umfasst die Schaltungsanordnung einen Pulsweitenmodulator. Der Pulsweitenmodulator ist zwischen dem Oszillator und dem Treiberschaltkreis geschaltet. Der Oszillatorausgang ist mit einem Eingang des Pulsweitenmodulators verbunden. Ein Modulatorausgang des Pulsweitenmodulators ist mit dem Treibersignaleingang verbunden. Ein weiterer Modulatorausgang des Pulsweitenmodulators ist mit einem weiteren Treibersignaleingang des Treiberschaltkreises verbunden. Ein Ausgang der Steuereinheit ist mit einem Modulatorsteuereingang des Pulsweitenmodulators verbunden. Am Piezotransformator kann eine sekundärseitige Spannung abgegriffen werden, die z.B. zur Blitzauslösung dient.

In der deutschen Offenlegungsschrift DE 10 2007 055 014 A1 ist ein Verfahren zur Zündung und Aufrechterhaltung eines Plasmas in einem Gasraum offenbart. Das piezoelektrische Material ragt in einen Hohlraum hinein, wobei das piezoelektrische Material durch eine äußere elektrische Anregung resonant in Schwingungen versetzt wird. Der Hohlraum enthält das zu ionisierende Gas. Außen sind an dem piezoelektrischen Material Elektroden angebracht. Das Verfahren ist zur Realisierung einer Plasmalichtquelle geeignet.

Die chinesische Patentanmeldung CN 101259036 A offenbart einen Mikro-Plasma-Stift zum Entfernen von Sommersprossen. Der Stift umfasst einen Plasmakopf zur Hautreinigung, ein Griffgehäuse, einen Mikro-Wandler, der im Griffgehäuse angeordnet ist, einen Leistung Controller und ein Leistungsmodul. Der Stift kann eine hohe und variable Plasmaleistung abgeben, wofür eine integrierte Schaltung oder einem Halbleiter-Chip-Mikroprozessor im Griffgehäuse installiert ist, die einen piezoelektrischen Transformator treibt.

Die europäische Patentanmeldung EP 2 256 835 A2 offenbart einen Impulsgenerator für einen piezoelektrischen Transformator. Eine Endstufe des Verstärkers treibt den piezoelektrischen Transformator bei einer gewünschten Resonanzfrequenz. Zwei Elektroden sind mit dem piezoelektrischen Transformator verbunden. Die sich am piezoelektrischen Transformator ausbildende Spannung reicht aus um eine dielektrische Barriereentladung auszubilden. Der Generator für die dielektrische Barriereentladung besteht aus einer Röhre oder einer Schale. Die Hochspannungselektrode sitzt z.B. in einer auf Erdpotential liegenden Röhre.

Die deutsche Patentschrift DE 10 2005 032 890 B4 offenbart eine Vorrichtung zur Erzeugung von Atmosphärendruck-Plasma mittels mindestens eines piezoelektrischen Transformators. Ein solcher Transformator besteht aus piezoelektrischem Material, das in Längsrichtung in mindestens einer Anregungszone und mindestens einer Hochspannungszone unterteilt ist. Gemäß der Erfindung weist der piezoelektrische Transformator mindestens eine Öffnung zur Gasführung auf, die mit einem Gasstrom durchströmt wird, wobei in der Öffnung Plasma erzeugt werden kann.

Die deutsche Gebrauchsmusterschrift DE 20 2008 008 980 U1 offenbart eine Vorrichtung zur Erzeugung eines Atmosphärendruck-Plasmas. Eine mit einer Gasleitung verbindbare Gaseintrittsöffnung und eine Zuleitung für eine Spannungsversorgung der Vorrichtung sind beide mit einer Leistungsversorgungseinrichtung verbunden.

Die japanische Patentanmeldung JP 2003-297295 offenbart ein Licht emittierendes Element, das ein piezoelektrisches Element umfasst. Das piezoelektrische Element wird mittels einer Wechselspannung angeregt.

Die deutsche Offenlegungsschrift DE 10 2008 063 052 A1 offenbart eine Vorrichtung zur Reinigung von Raumluft. Die Vorrichtung umfasst ein Gehäuse, an dem mindestens eine Öffnung zum Ansaugen von Umgebungsluft und mindestens eine Austrittsöffnung zum Ausblasen der gereinigten Luft vorgesehen sind. Dabei ist in dem Gehäuse eine Einrichtung zur Erzeugung von Plasma angeordnet, so dass Keime oder unangenehme Gerüche beseitigt werden können. Der Artikel "Piezoelektrische Transformatoren - Schaltungen und Anwendungen" vom C. KAUCZOR / T. SCHULTE / H. GROTSTOLLEN; 47. Internationales Kolloquium, Technische Universität Ilmenau, 23. - 26. September 2002. Die piezoelektrischen Transformatoren stellen eine geeignete Alternative zu herkömmlichen Transformatoren dar. Auf der Primärseite wird die treibende Spannung eingekoppelt. Auf der Ausgangsseite (Sekundärseite) wird die Spannung verstärkt.

Im Artikel "High Efficiency Ozone Production bya Compact Ozoniser Using Piezoelectric Tranformer", von Kenji TERANISHI, Susumu SUZUKI und Haruro ITOH, Chiba Institute of Technology, ist offenbart, dass der piezoelektrische Transformator in Schwingungsknoten gehaltert ist. Die Anregungsenergie wird in einer ersten Hälfte des piezoelektrischen Transformators zugeführt. Die zweite Hälfte des piezoelektrischen Transformators ist zwischen zwei Elektroden für die Barriereentladung positioniert. Eine Plasmaausbildung alleine am freien Ende des piezoelektrischen Transformators ist nicht vorgesehen.

Der Artikel von NADAL C. et al. betrifft: "First Approach for the Modelling of the Electric Field Surrounding a Piezoelectric Transformer in View of Plasma Generation", IEEE TRANSACTIONS ON MAGNETICS, NEW YORK, US, Bd. 48, Nr. 2, 2. Februar 2012, Seiten 423-426, XP011398344.

Der Artikel von TERANISHI K. et al. betrifft: "A novel generation method of dielectric barrier discharge and ozone production using a piezoelectric transformer", JAPANESE JOURNAL OF APPLIED PHYSICS; PART. 2, TOKYO; JP, Bd. 43, Nr. 9B, 2, September 2004, Seiten 6733-6739, XP002432140.

Der Artikel von TESCHKE M., EGEMANN J. betrifft: "Low voltage APPgeneration by piezo ceramics: A new revolutionary enabling technology", 18th INTERNAT. SYMPOSIUM ON PLASMA CHEMISTRY (ISPC), Kyoto, Japan, Paper 27A-A4, 26 - 31. August 2007, XP7922582.

Die Erfindung betrifft eine Vorrichtung zur Erzeugung von Atmosphärendruck-Plasma mittels mindestens eines piezoelektrischen Transformators. Ein solcher Transformator besteht aus piezoelektrischem Material, das in Längsrichtung in mindestens einer Anregungszone und mindestens einer Hochspannungszone unterteilt ist. Gemäß der Erfindung weist der piezoelektrische Transformator mindestens eine Öffnung zur Gasführung auf, die mit einem Gasstrom durchströmt wird, wobei in der Öffnung Plasma erzeugt werden kann. Nach einer anderen Ausführungsform der Erfindung sind die Polarisationsrichtungen der beiden Zonen des Transformators derart ausgebildet, dass an der Oberfläche der Hochspannungszone selbst Plasma erzeugt wird, wie z. B. zur Lampenstromversorgung mit entsprechenden Elektroden.

Die Aufgabe der vorliegenden Erfindung besteht darin, eine Vorrichtung zu schaffen, die einfach und kostengünstig ist, so dass unter Verwendung der Vorrichtung ein Plasma bei Atmosphärendruck erzeugt wird.

Die obige Aufgabe wird mit einer Vorrichtung gemäß den Merkmalen des Anspruchs 1 gelöst.

Eine weitere Aufgabe der Erfindung ist, ein Handgerät zur Plasmabehandlung von Oberflächen bei Atmosphärendruck vorzuschlagen, das kostengünstig und einfach aufgebaut ist.

Die obige Aufgabe wird mit einem Handgerät zur Plasmabehandlung von Oberflächen gemäß den Merkmalen des Anspruchs 11 gelöst.

Die erfindungsgemäße Vorrichtung zur Erzeugung eines Plasmas zeichnet sich durch eine Steuerschaltung aus, die zur Anregung eines piezoelektrischen Transformators mit diesem elektrisch verbunden ist. Der piezoelektrische Transformator ist aus mehreren einzelnen Schichten aufgebaut. Der piezoelektrische Transformator besteht aus einem Stapel von mehreren Folien aus dielektrischem Material, wobei in einem Abschnitt einer jeden Folie eine Leiterbahn bzw. eine leitfähige Fläche aufgebracht ist. Der Abschnitt der Folie mit der Leiterbahn befindet sich in einem Abschnitt des ersten Endes des piezoelektrischen Transformators. In einem Sinterprozess werden die einzelnen Folien miteinander verbunden und so der piezoelektrische Transformators gebildet.

Die Steuerschaltung zum Antreiben des piezoelektrischen Transformators ist auf einer Platine realisiert. In der Regel wird der piezoelektrische Transformator mit einer Spannung beaufschlagt, die den piezoelektrischen Transformator gemäß seiner Resonanzfrequenz anregt. Die Steuerschaltung dient ebenfalls zur Nachregelung der Anregungsspannung, falls sich die Resonanzfrequenz des piezoelektrischen Transformators aufgrund von Temperatureinflüssen oder Alterungsprozessen ändert. Ebenso kann sich die Resonanzfrequenz des piezoelektrischen Transformators durch Änderung der dielektrischen Eigenschaften der Umgebung oder durch die Intensität der in die gasförmige Umgebung gezündeten Entladung verschieben. Der piezoelektrische Transformator ist mit einem Bereich eines ersten Endes über der Platine gehaltert bzw. geführt. Durch die Anregungsspannung wird an einem zweiten freien Ende des piezoelektrischen Transformators eine Hochspannung ausgeprägt. Am zweiten freien Ende zündet dann das Plasma bei Atmosphärendruck. Die Halterung für den piezoelektrischen Transformator haltert bzw. führt diesen in einem Schwingungsknoten. Zwischen der Platine und dem piezoelektrischen Transformator ist ein Spalt ausgebildet, so dass der piezoelektrische Transformator und die Platine voneinander beabstandet sind. Mittels dieser Anordnung ist eine mechanische Dämpfung des piezoelektrischen Transformators ausgeschlossen.

Der piezoelektrische Transformator selbst ist quaderförmig, wobei eine Länge und eine Breite des piezoelektrischen Transformators größer als eine Dicke des piezoelektrischen Transformators sind. Die mehreren Schichten des piezoelektrischen Transformators sind dabei derart orientiert, dass sie im Wesentlichen senkrecht zu den Seitenflächen des piezoelektrischen Transformators sind, die durch die Länge und die Dicke des piezoelektrischen Transformators bestimmt sind.

An gegenüberliegenden Seitenflächen des piezoelektrischen Transformators ist jeweils ein elektrischer Anschluss für die Anregungsspannung vorgesehen. Bevorzugt wird der elektrische Anschluss in einem Schwingungsknoten des piezoelektrischen Transformators angebracht. Die Halterung für den piezoelektrischen Transformator ist ebenfalls im Schwingungsknoten des piezoelektrischen Transformators vorgesehen. Für den Fall, dass ein separater elektrischer Anschluss für die Anregungsspannung zum Anschlusspad geführt wird, reicht es aus, dass die Halterung aus elastischem Material besteht. Falls die Anregungsenergie für den piezoelektrischen Transformator über die Halterung zugeführt wird, ist das Material der Halterung elastisch und elektrisch leitfähig.

Ein Strom eines Arbeitsgases wird derart ausbildet, dass er zumindest von dem ersten Ende des auf der Platine gehalterten piezoelektrischen Transformators zum zweiten freien Ende des piezoelektrischen Transformators hin, gerichtet ist. Der Strom von Arbeitsgas dient zur Ausbildung des Plasmas und zur Kühlung des piezoelektrischen Transformators, wobei in den Schwingungsknoten die höchste thermische Verlustleistung auftritt. Ein Lüfter ist vorgesehen, um den Storm des Arbeitsgases über den piezoelektrischen Transformator zum zweiten freien Ende hin zu unterstützen.

Bei einem mit einer Resonanzfrequenz angeregten, piezoelektrischen Transformator bilden sich mindestens zwei Schwingungsknoten aus, die beide vom ersten Ende bzw. vom zweiten freien Ende beabstandet sind. Gemäß einer Ausführungsform ist auf der Platine jeweils ein elektrischer Anschluss zu je einer Seitenfläche des piezoelektrischen Transformators geführt. Der Anschluss ist mit je einem Anschlusspad verbunden, das in einem Schwingungsknoten an jeder Seitenfläche des piezoelektrischen Transformators vorgesehen ist. Das Anschlusspad ist an denjenigen Schwingungsknoten angebracht, der näher zum ersten Ende als zum zweiten freien Ende hin liegt. Bevorzugt ist an diesem Schwingungsknoten des piezoelektrischen Transformators ein Temperatursensor vorgesehen, damit die Temperatur des piezoelektrischen Transformators überwacht werden kann, so dass eine Abschaltung vorgenommen wird, wenn die Temperatur einen gewissen Schwellwert übersteigt.

Es ist von besonderem Vorteil, wenn die Platine und der piezoelektrische Transformator eine bauliche Einheit bilden. Diese bauliche Einheit kann dann als Ganzes in ein Gehäuse eingesetzt bzw. eingebaut werden.

Ein Handgerät zur Plasmabehandlung von Oberflächen besitzt zumindest ein Gehäuse und eine Spannungsquelle. Mit dem von dem Handgerät abgegebenen Plasma ist es möglich eine Oberfläche zu reinigen und die Hafteigenschaften von Lack oder Klebstoff zu verbessern. Im Gehäuse ist eine Platine mit einer Steuerschaltung zur Anregung eines piezoelektrischen Transformators angeordnet, wobei der piezoelektrische Transformator mit einem ersten Ende auf der Platine gehaltert ist und somit eine bauliche Einheit mit dieser bildet. Ein zweites freies Ende des piezoelektrischen Transformators ist zu einer Öffnung im Gehäuse hin ausgerichtet. An dem zweiten freien Ende des piezoelektrischen Transformators prägt sich eine Hochspannung aus, so dass das Plasma bei Atmosphärendruck ausgebildet wird. Zu Energieversorgung sind ein Akku und/oder ein Anschluss für ein Standard-Netzteil vorgesehen.

Das Gehäuse trägt einen Lüfter, mit dem ein Luftstrom über den piezoelektrischen Transformator und hin zur Öffnung im Gehäuse erzeugbar ist. Der Lüfter, kann in Abhängigkeit von den baulichen Gegebenheiten des Gehäuses als Axiallüfter ausgebildet sein.

Das Handgerät kann mit einem zusätzlichen Gasanschluss versehen sein. Über den Gasanschluss kann ein anderes Arbeitsgas als Luft dem zweiten freien Ende des piezoelektrischen Transformators zugeführt werden. Es ist ebenso denkbar, dass das über den Gasanschluss kommende Arbeitsgas mit der Umgebungsluft gemischt wird.

Es ist von besonderem Vorteil, dass mit der erfindungsgemäßen Vorrichtung ein Atmosphärendruck-Plasma mittels mindestens eines piezoelektrischen Transformators erzeugt werden kann. Der piezoelektrische Transformator besteht aus piezolelektrischem Material, das in Längsrichtung in mindestens eine Anregungszone und mindestens eine Hochspannungszone unterteilt ist, wobei die Anregungszone Anschlusspads aufweist, an die eine Wechselspannung angelegt wird und wobei in der Anregungszone mechanische Schwingungen erzeugt werden die in der Hochspannungszone den Aufbau elektrischer Felder bewirken. Hinzu kommt, dass sich die gegenwärtige Erfindung in ein Handgerät integrieren lässt. Das Handgerät ist einfach zu transportieren und kann somit ohne besonderen Aufwand zu jedem gewünschten Einsatzort gelangen. Ebenso ist die Energieversorgung einfach gestaltet, was ebenfalls die Variabilität hinsichtlich der Einsatzmöglichkeiten positiv unterstützt.

Gemäß der Erfindung wird das Volumen des pro Zeiteinheit erzeugten Plasmas durch geometrische Strukturen zur lokalen Feldüberhöhung maximiert. Durch eine Strukturierung der Hochspannungsseite des Piezokristalls wird das Volumen des pro Zeiteinheit erzeugten Plasmas maximiert. Die Strukturierung ist in unmittelbaren Formschluss mit der Hochspannungsseite des Piezokristalls. Die Strukturierung ist als gesondertes Bauelement ausgebildet, das mit der Hochspannungsseite des Piezokristalls direkt elektrisch verbunden ist. Im Bereich der Feldüberhöhung wird der Piezokristall (piezoelektrische Transformator) von einem Arbeitsgas (Prozessgas) überströmt.

Weitere Vorteile und vorteilhafte Ausgestaltungen der Erfindung sind Gegenstand der nachfolgenden Figuren sowie deren Beschreibungsteile.

Es zeigen im Einzelnen:
- **Figur 1**: eine schematische Ansicht des Grundprinzips der erfindungsgemäßen Vorrichtung, mit der ein Plasma bei Atmosphärendruck erzeugt werden kann;
- **Figur 2**: eine perspektivische Schnittansicht, wobei die erfindungsgemäße Vorrichtung von einem Gehäuse umgeben ist;
- **Figur 3**: eine Seitenansicht der erfindungsgemäßen Vorrichtung im Gehäuse;
- **Figur 4**: eine perspektivische Ansicht einer Ausführungsform des Gehäuses, in dem die erfindungsgemäße Vorrichtung untergebracht ist;
- **Figur 5**: eine Draufsicht auf die erfindungsgemäße Vorrichtung;
- **Figur 6**: eine Seitenansicht der erfindungsgemäße Vorrichtung;
- **Figur 7**: eine Seitenansicht des piezoelektrischen Transformators zur Darstellung des Schichtaufbaus;
- **Figur 8**: eine Draufsicht auf die einzelnen Schichten des piezoelektrischen Transformators zur Darstellung der Kontaktierung mit dem seitlichen Anschlüssen zur Zuführung der Anregungsenergie;
- **Figur 9a - 9b**: schematische Ansichten der unterschiedlichen Möglichkeiten zur Halterung des piezoelektrischen Transformators;
- **Figur 10**: eine Ansicht der unterschiedlichen physikalischen Zustände als Funktion der Länge des piezoelektrischen Transformators;
- **Figur 11**: eine mögliche Ausführungsform eines Handgeräts, das die erfindungsgemäße Vorrichtung umschließt; und
- **Figur 12**: eine weitere Ausführungsform eines Handgeräts, das die erfindungsgemäße Vorrichtung umschließt.

Für gleiche oder gleich wirkende Elemente der Erfindung werden identische Bezugszeichen verwendet. Das dargestellte Ausführungsbeispiel stellt lediglich eine Möglichkeit dar, wie eine Vorrichtung zur Erzeugung eines Plasmas und ein Handgerät, in dem die Vorrichtung zur Erzeugung eines Plasmas eingebaut ist, ausgestaltet sein können.

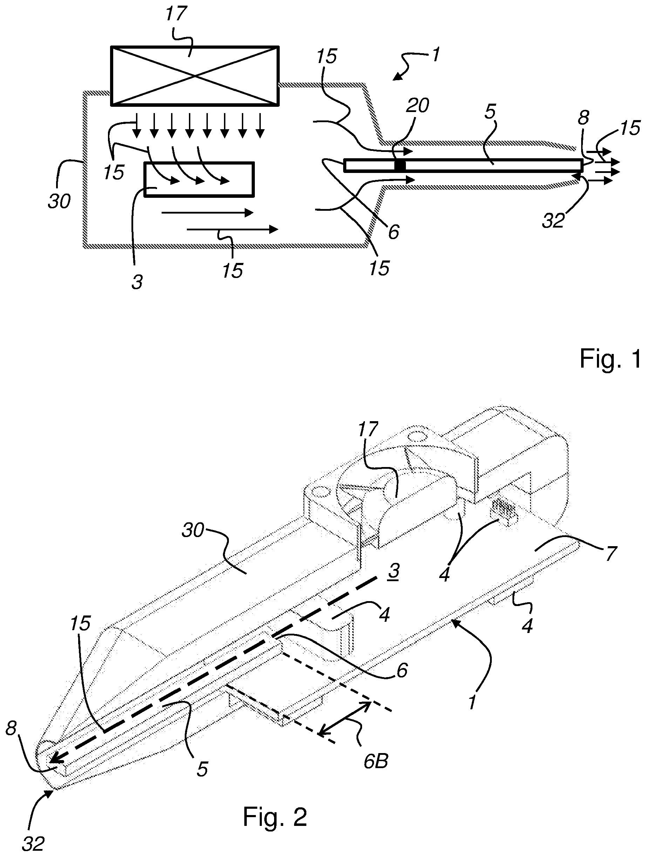

**Figur 1** zeigt eine schematische Ansicht des Grundprinzips der erfindungsgemäßen Vorrichtung 1, mit der ein Plasma bei Atmosphärendruck erzeugt werden kann. In einem Gehäuse 30 ist ein piezoelektrischer Transformator 5 angeordnet. Ein zweites freies Ende 8 des piezoelektrischen Transformators 5 ist zu einer Öffnung 32 des Gehäuses 30 hin gerichtet. Dem Gehäuse 30 ist ein Lüfter 17 zugeordnet, der einen Strom 15 eines Arbeitsgases erzeugt, der zur Öffnung 32 des Gehäuses 30 hin geführt ist. Der Strom 15 des Arbeitsgases ist über die Steuerschaltung 3 und den piezoelektrischen Transformator 5 geführt und dient im Wesentlichen zur Kühlung des piezoelektrischen Transformators 5. Die in der Figur 1 gezeigte Anordnung des Lüfters 17 soll nicht als Beschränkung der Erfindung aufgefasst werden. Es ist für einen Fachmann selbstverständlich, dass der Lüfter 17 an jeder beliebigen Stelle des Gehäuses 30 angebracht werden kann.

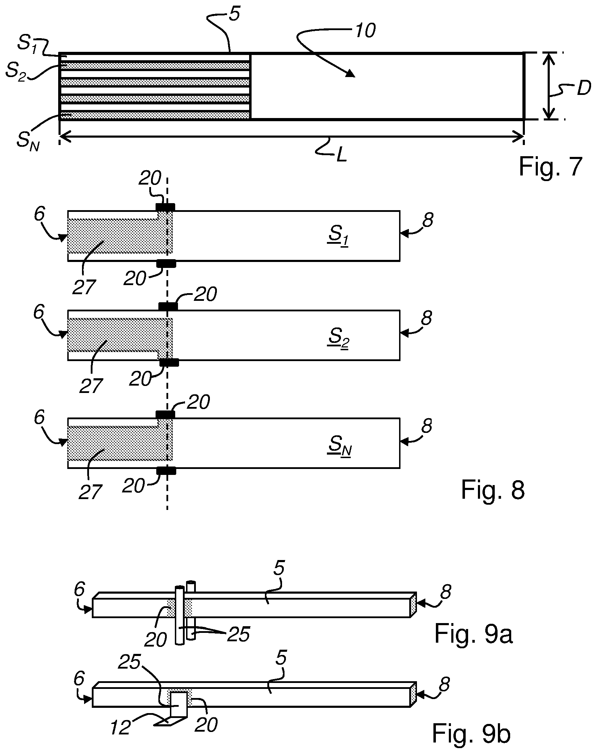

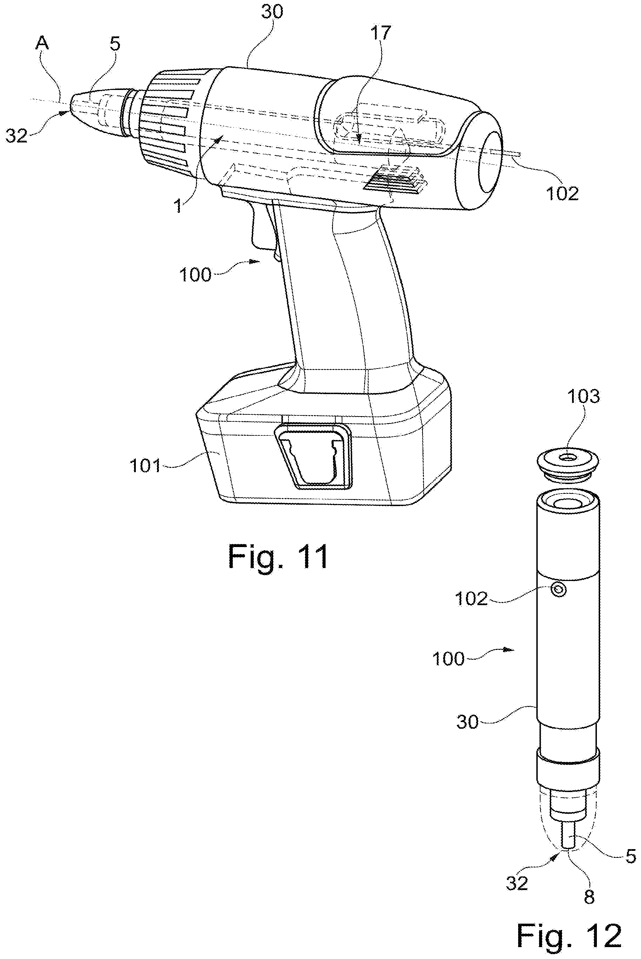

An jeder einer Seitenfläche 10 des piezoelektrischen Transformators 5 ist je ein Anschlusspad 20 vorgesehen, über die der piezoelektrische Transformator 5 mit einer derartigen Spannung beaufschlagt wird, so dass der piezoelektrische Transformators 5 mit einer Resonanzfrequenz schwingt. Das Anschlusspad 20 liegt dabei näher zum ersten Ende 6 des piezoelektrischen Transformators 5 als zum zweiten freien Ende 8. Wie in Figur 11 dargestellt ist, bildet der angeregte piezoelektrische Transformator 5 zwei Schwingungsknoten 14 aus. Bevorzugt sind die Anschlusspads 20 in dem Schwingungsknoten 14 angebracht, der näher zum ersten Ende 6 des piezoelektrischen Transformators 5 liegt. Bevorzugt ist der piezoelektrischen Transformator 5 derart bemessen, dass sich bei einer Grundmode entlang der Länge des piezoelektrischen Transformators 5 zwei Schwingungsknoten 14 (siehe Figur 9) ausbilden.

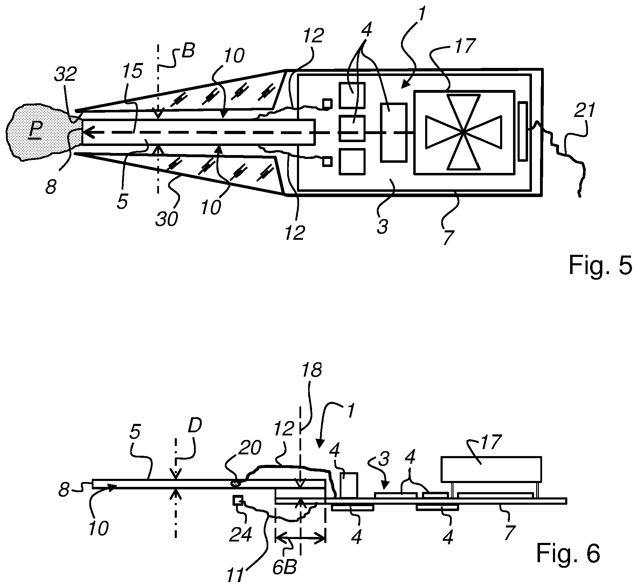

**Figur 2** zeigt eine perspektivische Schnittansicht des Gehäuses 30, das die erfindungsgemäße Vorrichtung 1 umgibt. Der piezoelektrische Transformator 5 ist, auf einer Platine 7 gehaltert, auf der eine Steuerschaltung 3 realisiert ist, die ihrerseits aus mehreren elektronischen Bauelementen 4 aufgebaut ist, wobei der Übersicht halber nur ein Teil der elektronischen Bauelemente 4 dargestellt ist. Der piezoelektrische Transformator 5 kann gemäß einer ersten Ausführungsform mit einem Bereich 6B des ersten Endes 6 der Platine 7 gegenüberliegen und ist, wie später beschrieben wird, von dieser beabstandet gehaltert. Das Gehäuse 30 hat die Öffnung 32 ausgebildet, in der das zweite freie Ende 8 des piezoelektrischen Transformator 5 endet. An dem zweiten freien Ende 8 des piezoelektrischen Transformators 5 liegt eine Hochspannung an, so dass sich ein Plasma P (siehe Figur 5) bei Atmosphärendruck ausbildet. Mit dem Lüfter 17 wird, wie bereits beschrieben, ein Strom 15 an Arbeitsgas erzeugt, so dass sich mit dem Arbeitsgas am zweiten freien Ende 8 des piezoelektrischen Transformators 5 das Plasma P ausbilden kann.

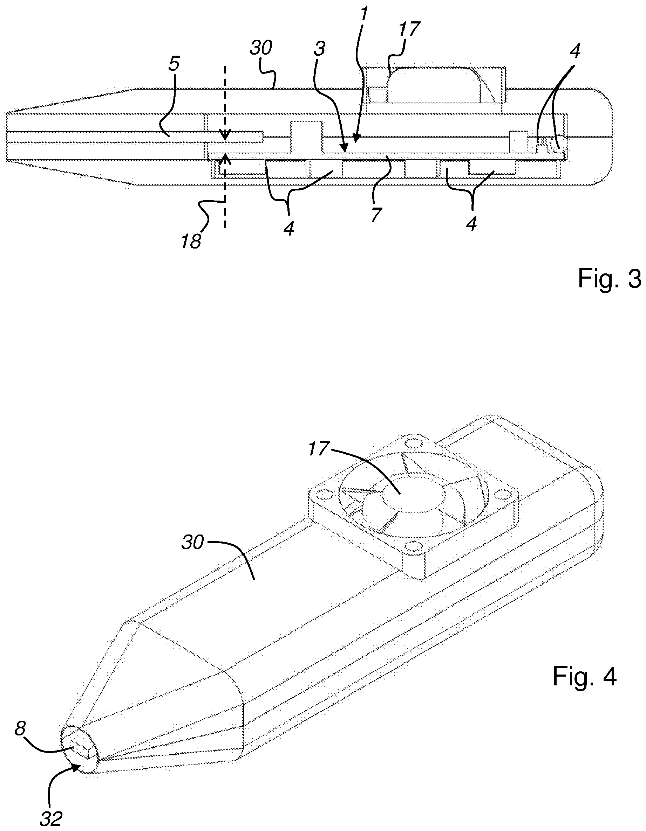

**Figur 3** zeigt eine Seitenansicht der erfindungsgemäßen Vorrichtung 1 im Gehäuse 30. Wie bereits aus Figur 2 und ebenso aus Figur 3 ersichtlich ist, bilden der piezoelektrische Transformator 5 und die Platine 7, die die Steuerschaltung 3 trägt, die aus mehreren elektronischen Bauelementen 4 aufgebaut ist, eine bauliche Einheit. Somit kann die erfindungsgemäße Vorrichtung 1 als die bauliche Einheit vorproduziert und dann in das dafür vorgesehene Gehäuse 30 eingebaut werden. In dieser Darstellung ist ein freier Spalt 18 zwischen der Platine 7 und dem piezoelektrische Transformator 5 zu erkennen.

In **Figur 4** ist eine perspektivische Ansicht einer Ausführungsform des Gehäuses 30 dargestellt. In dem Gehäuse 30 ist die erfindungsgemäße Vorrichtung 1 untergebracht. In der hier gezeigten Darstellung von der erfindungsgemäßen Vorrichtung 1 ist lediglich das zweite freie Ende 8 des piezoelektrischen Transformators 5 zu sehen, das in der Öffnung 32 des Gehäuses 30 endet.

Eine schematische Draufsicht auf die erfindungsgemäße Vorrichtung 1 ist in **Figur 5** dargestellt. Wie bereits mehrfach in der vorangehenden Beschreibung erwähnt, ist die erfindungsgemäße Vorrichtung 1 eine bauliche Einheit aus dem piezoelektrischen Transformator 5 und der Platine 7. Die Platine 7 realisiert mit einer Vielzahl von elektronischen Bauelementen 4 eine Steuerschaltung 3. Mit der Steuerschaltung 3 ist es möglich den piezoelektrischen Transformator 5 mit seiner Resonanzfrequenz anzuregen. Die erfindungsgemäße Vorrichtung 1 kann mit einer externen Energieversorgung verbunden werden, die ein herkömmliches Standard-Netzteil (nicht dargestellt) ist, das über ein Kabel 21 mit der erfindungsgemäße Vorrichtung 1 verbunden wird. Ebenso kann die Erfindungsgemäße Vorrichtung mit einem Akku versehen werden. Eine Kombination aus Akku und Standard-Netzteil ist ebenfalls denkbar. Die Ansteuerspannung wird von der Steuerschaltung 3 der Platine 7 über je einen elektrischen Anschluss 12 an je eine Seitenfläche 10 des piezoelektrischen Transformators 5 angelegt. Durch die an den Seitenflächen 10 des piezoelektrischen Transformators 5 anliegende Anregungsspannung bildet sich am zweiten freien Ende 8 des piezoelektrischen Transformators 5 eine Hochspannung aus. Der der erfindungsgemäßen Vorrichtung 1 zugeordnete Lüfter 17 erzeugt einen Strom 15 aus Arbeitsgas, mit dem das Plasma P am zweiten freien Ende 8 gezündet und aufrecht erhalten wird. Das Plasma P tritt durch die Öffnung 32 des Gehäuses aus, in dem sich die erfindungsgemäße Vorrichtung 1 befindet. Die Zündung und die Aufrechterhaltung des Plasmas P erfolgt bei Atmosphärendruck.

Die Seitenansicht der erfindungsgemäßen Vorrichtung 1 ist in **Figur 6** dargestellt. Auf der Platine 7 ist die Steuerschaltung 3 mit einer Vielzahl von elektrischen Bauelementen 4 realisiert. Der piezoelektrische Transformator 5 ist mit dem Bereich 6B des ersten Endes 6 frei über der Platine 7 angeordnet. An jeder der Seitenflächen 10 des piezoelektrischen Transformators 5 ist das Anschlusspad 20 für den elektrischen Anschluss 12 von der Platine 7 angebracht. Die elektrischen Anschlusspads 20 sind an beiden Seitenflächen 10 des piezoelektrischen Transformators 5 und im Schwingungsknoten 14 (siehe Figur 9) desselben angebracht. Ebenso erfolgt die mechanische Halterung bzw. Führung des piezoelektrischen Transformators 5 im Schwingungsknoten 14. Die Halterung bzw. Führung des piezoelektrischen Transformators 5 ist also derart, dass zwischen der Platine 7 und dem piezoelektrischen Transformator 5 ein Spalt 18 vorliegt. Mit der erfindungsgemäßen Vorrichtung 1 ist es am zweiten freien Ende 8 des piezoelektrischen Transformators 5 eine Hochspannung zu erzeugen, wenn in den beiden Auschlusspads 20 eine Niederspannung von z. B. 12V Wechselspannung (12V Peak-to-Peak) angelegt wird. Wie bereits mehrfach erwähnt, ist der Platine 7 ein Lüfter 17 zugeordnet, der für den zur Kühlung des piezoelektrischen Transformators 5 erforderlichen Luftstrom sorgt. Dem Anschlusspad 20 kann ein Temperatursensor 24 zugeordnet sein, der die Temperatur im Bereich des Anschlusspads 20 bestimmt. Die Signale des Temperatursensors 24 können über eine Verbindung 11 zur Platine 7 geführt werden. Wie in der Beschreibung zu Figur 11 klargestellt ist, ist im Bereich des Anschlusspads 20 (Lage des Schwingungsknotens 14) die thermische Verlustleistung am größten. In Figur 6 ist das Messprinzip des Temperatursensors 2 als ein berührungsloses Messprinzip dargestellt. Es ist ebenfalls denkbar, dass der Temperatursensor 24 im Anschlusspad 20 eingelötet ist. Wie in der Beschreibung zu Figur 5 und Figur 6 zu erkennen ist, hat der piezoelektrischen Transformator 5 eine Breite B und eine Dicke D.

In **Figur 7** ist eine Seitenansicht des piezoelektrischen Transformators 5 schematisch wiedergegeben, die den Schichtaufbau des piezoelektrischen Transformators 5 verdeutlicht. Der piezoelektrische Transformator 5 ist zumindest zum Teil über seine Länge L aus mehreren Schichten S₁, S₂, ...,S_{N}, aufgebaut, die im Wesentlichen senkrecht zur der aus Länge L und der Dicke D des piezoelektrischen Transformators 5 definierten Seitenfläche 10 liegen. Der piezoelektrische Transformator 5 besteht aus einem Stapel von mehreren Folien aus dielektrischem Material, wobei in einem Abschnitt einer jeden Folie eine Leiterbahn aufgebracht ist. In einem Sinterprozess werden die einzelnen Folien miteinander verbunden und so der piezoelektrische Transformator gebildet. Die elektrische Kontaktierung der einzelnen Schichten S₁, S₂, ...,S_{N} ist in **Figur 8** dargestellt. Wie bereits in der vorangehenden Beschreibung erwähnt, ist an jeder der Seitenflächen 10 ein Anschlusspad 20 vorgesehen, das sich über die gesamte Dicke D des piezoelektrischen Transformators 5 erstreckt. Jeder der Schichten S₁, S₂, ...,S_{N} ist mit einer L-förmigen Leiterschicht 27 versehen. Die L-förmigen Leiterschichten 27 sind im Schichtsystem derart angeordnet, dass alternierend eines der beiden Anschlusspads 20 kontaktiert wird, woraus eine Parallelschaltung der einzelnen Schichten S₁, S₂, ...,S_{N} resultiert. Wie bereits erwähnt sind die Anschlusspads 20 auf beiden Seitenflächen 10 des piezoelektrischen Transformators 5, in dessen Schwingungsknoten, angebracht.

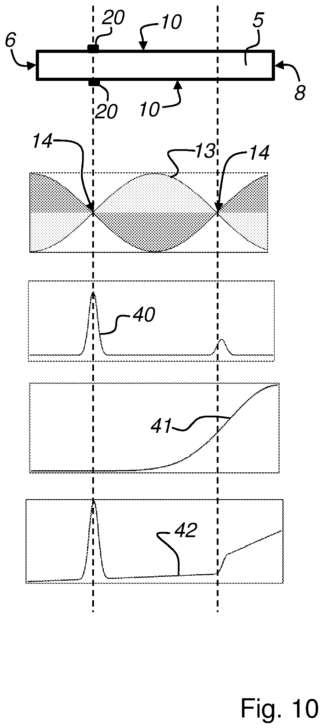

In den **Figuren 9a und 9b** sind verschiedene Ausführungsformen der Halterung bzw. Führung des piezoelektrischen Transformators 5 offenbart. Figur 9a zeigt die Halterung 25 des piezoelektrischen Transformators 5 gemäß der Durchsteckmontage (through-hole technology, THT) Die Halterung 25 besteht gemäß dieser Ausführungsform aus zwei Stiften die den Durchlass für die Durchsteckmontage bilden, in den der piezoelektrische Transformator 5 eingesteckt und gehalten wird. Die in Figur 9b gezeigte Art der Halterung des piezoelektrischen Transformators 5, ist die eines oberflächenmontierten Bauelements (surfacemounted device, SMD). Die elektrischen Anschlüsse 12 werden mittels lötfähiger Anschlussflächen direkt auf der Platine (hier nicht dargestellt) montiert. Die elektrischen Anschlüsse 12 halten den piezoelektrischen Transformators 5 an dessen Anschlusspads 20 mittels entsprechender Elemente, die die Halterung 25 bilden. Die Halterung 25 besteht gemäß der in Figur 9b gezeigten Ausführungsform aus flächigen Elementen. Es ist von Vorteil, wenn das Material der Halterung 25 elastisch und elektrisch leitfähig ist. **Figur 10** zeigt eine Ansicht der unterschiedlichen physikalischen Zustände als Funktion der Länge des piezoelektrischen Transformators 5. Die Erregung des piezoelektrischen Transformators 5 im Bereich seiner Resonanzfrequenz führt zur Ausbildung einer Schwingungsmode 13, die zwei Schwingungsknoten 14 im piezoelektrischen Transformator 5 ausbildet. Die Anschlusspads 20 sind an denjenigen Schwingungsknoten 14 positioniert, der näher zum ersten Ende 6 des piezoelektrischen Transformators 5 liegt. Durch die Schwingung des piezoelektrischen Transformators 5 bildet sich eine thermische Verlustleistung 40 aus, die am Schwingungsknoten 14 im Bereich des ersten Endes 6 des piezoelektrischen Transformators 5 am größten ist. An jedem Schwingungsknoten 14 tritt eine thermische Verlustleistung 40 auf. Am zweiten freien Ende 8 des piezoelektrischen Transformators 5 ist der E-Feldverlauf 41 derart, dass sich dort ein Maximum ausbildet. Die Strömungsgeschwindigkeit 42 des Arbeitsgases ist am Schwingungsknoten 14 im Bereich des ersten Endes 6 am größten. Ab dem Schwingungsknoten 14, im Bereich des zweiten freien Endes 6, nimmt die Strömungsgeschwindigkeit 42 bis zum zweiten freien Ende 8 zu.

**Figur 11** zeigt eine mögliche Ausführungsform eines Handgeräts 100, das die erfindungsgemäße Vorrichtung 1 umschließt. Das Handgerät 100 ist kabellos und wird über einen Akku 101 (in der Regel 12V), zur Anregung des piezoelektrischen Transformators 5, mit Energie versorgt. Zusätzlich kann einer Gasanschluss 102 vorgesehen sein, über den das Handgerät 100 mit einem Arbeitsgas versorgt wird, das nicht Luft ist. Ferner ist eine Lüfter 17 vorgesehen, der in Richtung einer Achse A der erfindungsgemäßen Vorrichtung 1 wirkt. Der Lüfter 17 sorgt dafür, dass innerhalb des Handgeräts 100 das Arbeitsgas (in der Regel Umgebungsluft) zum zweiten freien Ende des piezoelektrischen Transformators 5 transportiert wird. Das strömende Arbeitsgas sorgt ebenfalls für eine Kühlung des piezoelektrischen Transformators 5 und somit einem Abtransport der thermischen Verlustleistung. Das Handgerät 100 hat ein Gehäuse 30, in dem die Vorrichtung 1 als Bauteil aufgenommen wird.

**Figur 12** ist eine weitere Ausführungsform eines Handgeräts 100, das die erfindungsgemäße Vorrichtung 1 umschließt. Das Handgerät 100 ist mit einem Anschluss 103 für ein Kabel eines Standard-Netzteils ausgebildet. Ebenso kann ein zusätzlicher Gasanschluss 102 vorgesehen sein, über den das Handgerät 100 mit einem Arbeitsgas (außer Umgebungsluft) versorgt wird. Das Handgerät 100 hat eine zylindrische Form, so dass sind im Inneren des Gehäuses 30 ebenfalls eine Lüfter (hier nicht dargestellt) anbietet, der das Arbeitsgas in Richtung der Öffnung 32 des Gehäuses 30 bzw. zu zweiten freien Ende 8 des piezoelektrischen Transformators 5 drängt.

Obwohl in der gegenwärtigen Beschreibung lediglich zwei Ausführungsformen für Handgeräte 100 offenbart sind, soll dies nicht als Beschränkung der Erfindung aufgefasst werden. Es ist für einen Fachmann selbstverständlich, dass das Gehäuse 30 des Handgeräts 100 unterschiedliche Formen annehmen kann. Einschneidend ist lediglich, dass eine Öffnung 32 im Gehäuse 30 ausgebildet ist, so dass das Plasma P bei Atmosphärendruck austreten kann.

### Bezugszeichenliste:

- 1: Vorrichtung
- 3: Steuerschaltung
- 4: elektronische Bauelemente
- 5: piezoelektrischer Transformator
- 6: erstes Ende
- 6B: Bereich
- 7: Platine
- 8: zweites freies Ende
- 10: Seitenfläche
- 11: Verbindung
- 12: elektrischer Anschluss
- 13: Schwingungsmode
- 14: Schwingungsknoten
- 15: Strom eines Arbeitsgases
- 17: Lüfter
- 18: Spalt
- 20: Anschlusspad
- 21: Kabel von Netzteil
- 24: Tempersensor
- 25: Halterung
- 27: Leiterschicht
- 28: Umhüllung
- 30: Gehäuse
- 32: Öffnung
- 40: thermische Verlustleistung
- 41: E-Feldverlauf
- 42: Strömungsgeschwindigkeit
- 50: Spannungsquelle
- 100: Handgerät
- 101: Akku
- 102: Gasanschluss
- 103: Anschluss
- A: Achse der Vorrichtung
- L: Länge
- B: Breite
- D: Dicke
- P: Plasma
- S₁, S₂, ..., S_{N}: Schichten

## Patentansprüche

1. Vorrichtung (1) zur Erzeugung eines Plasmas (P) mit einer Steuerschaltung (3), die zur Anregung eines piezoelektrischen Transformators (5) mit diesem elektrisch verbunden ist, einer Platine (7), auf der die Steuerschaltung (3) realisiert ist, wobei der piezoelektrische Transformator (5) mit einem Bereich (6B) eines ersten Endes (6) in Bezug zur Platine (7) gehaltert ist, an einem zweiten freien Ende (8) des piezoelektrischen Transformators (5) eine Hochspannung ausprägbar und das Plasma (P) bei Atmosphärendruck zündbar ist, und ein Strom (15) eines Arbeitsgases in einem Gehäuse (30), zur Ausbildung des Plasmas (P) und zur Kühlung des piezoelektrischen Transformators (5), der über die Steuerschaltung (3) und den piezoelektrischen Transformator (5) zu einer Öffnung (32 im Gehäuse (30) hin strömt,
**dadurch gekennzeichnet, dass**
der piezoelektrische Transformator (5) aus mehreren Schichten (S₁, S₂,..., S_{N}) aus dielektrischem Material aufgebaut ist, wobei die Schichten (S₁, S₂,..., S_{N}) miteinander verbunden sind und wobei jede Schicht (S₁, S₂,..., S_{N}) zumindest zum Teil mit einer Leiterschicht (27) versehen ist;
jeweils ein elektrisches Anschlusspad (20) an gegenüberliegenden Seitenflächen (10) und in einem Schwingungsknoten (14) des piezoelektrischen Transformators (5) angebracht ist;
elektrische Anschlüsse (12) von der Platine (7) zu den elektrischen Anschlusspads (20) führen; und
eine Halterung (25), die derart mit den Anschlusspads (20) zusammenwirkt, dass der piezoelektrische Transformator (5) in einem Bereich (6B) des ersten Endes (6) mit einem Spalt (18) über der Platine (7) beabstandet ist.

2. Vorrichtung (1) nach Anspruch 1, **wobei** der piezoelektrische Transformator (5) quaderförmig ist und eine Länge (L) und eine Breite (B) des piezoelektrischen Transformators (5) größer ist als eine Dicke (D) des piezoelektrischen Transformators (5).

3. Vorrichtung (1) nach Anspruch 1, **wobei** die Halterung (25) aus einem elastischen Material ist.

4. Vorrichtung (1) nach einem der vorangehenden Ansprüche, **wobei** der Strom (15) des Arbeitsgases derart ausgebildet ist, dass er zumindest von dem ersten Ende (6) des über der Platine (7) gehalterten piezoelektrischen Transformators (5) zum zweiten freien Ende (8) des piezoelektrischen Transformators (5) hin gerichtet ist.

5. Vorrichtung nach Anspruch 4, **wobei** ein Lüfter (17) vorgesehen ist, der den Strom (15) des Arbeitsgases über den piezoelektrischen Transformator (5) zum zweiten freien Ende (8) des piezoelektrischen Transformators (5) hin unterstützt.

6. Vorrichtung (1) nach einem der vorangehenden Ansprüche, **wobei** in einem mit einer Resonanzfrequenz angeregten, piezoelektrischen Transformator (5) mindestens zwei Schwingungsknoten (14) ausbildbar sind, die beide von ersten Ende (6) bzw. vom zweiten freien Ende (8) beabstandet sind.

7. Vorrichtung (1) nach Anspruch 6, **wobei** der Schwingungsknoten (14) näher zum ersten Ende (6) als zum zweiten freien Ende (8) des piezoelektrischen Transformators (5) hin liegt.

8. Vorrichtung (1) nach Anspruch 1, **wobei** mindestens einem Schwingungsknoten (14) des piezoelektrischen Transformators (5) ein Temperatursensor (24) zugeordnet ist.

9. Vorrichtung (1) nach Anspruch 1, **wobei** der elektrische Anschluss (12), die Halterung (25) für den piezoelektrischen Transformator (5) und die Halterung (25) aus einem Material ist, das elastisch und elektrisch leitfähig ist.

10. Vorrichtung (1) nach einem der vorangehenden Ansprüche, **wobei** die Platine (7) und der piezoelektrische Transformator (5) eine bauliche Einheit bilden.

11. Handgerät (100) zur Plasmabehandlung von Oberflächen, mit einem Gehäuse (30), einer Spannungsquelle (50) und einer im Gehäuse (30) vorgesehenen Platine (7), mit einer Steuerschaltung (3) zur Anregung eines piezoelektrischen Transformators (5), wobei der piezoelektrische Transformator (5) mit einem ersten Ende (6) der Platine (7) zugeordnet und ein zweites freies Ende (8) des piezoelektrischen Transformators (5) zu einer Öffnung (32) im Gehäuse (30) hin ausgerichtet ist,
wobei am zweiten freien Ende (8) des piezoelektrischen Transformators (5) eine Hochspannung ausprägbar und das Plasma (P) bei Atmosphärendruck zündbar ist,
wobei ein Strom (15) eines Arbeitsgases zur Ausbildung des Plasmas (P) und zur Kühlung des piezoelektrischen Transformators (5) über die Steuerschaltung (3) und den piezoelektrischen Transformator (5) strömt;
**dadurch gekennzeichnet, dass**
der piezoelektrische Transformator (5) aus mehreren Schichten (S₁, S₂,..., S_{N}) aus dielektrischem Material aufgebaut ist, wobei die Schichten (S₁, S₂,..., S_{N}) miteinander verbunden sind, wobei jede Schicht (S₁, S₂,..., S_{N}) zumindest zum Teil mit einer Leiterschicht (27) versehen ist;
jeweils ein elektrisches Anschlusspad (20) an gegenüberliegenden Seitenflächen (10) und in einem Schwingungsknoten (14) des piezoelektrischen Transformators (5) angebracht ist;
elektrische Anschlüsse (12) von der Platine (7) zu den elektrischen Anschlusspads (20) führen; und
eine Halterung (25), die derart mit den Anschlusspads (20) zusammenwirkt, dass der piezoelektrische Transformator (5) in einem Bereich (6B) des ersten Endes (6) des piezoelektrischen Transformators (5) durch einen Spalt (18), frei über der Platine (7), beabstandet ist und der piezoelektrische Transformator (5) und die Platine (7) eine bauliche Einheit bilden.

12. Handgerät (100) nach Anspruch 11, **wobei** dem mindestens einen Schwingungsknoten (14) des piezoelektrischen Transformators (5) ein Temperatursensor (24) zugeordnet ist.

13. Handgerät (100) nach einem der Ansprüche 11 bis 12, **wobei** das Gehäuse (30) einen Lüfter (17) trägt, mit dem ein Luftstrom über den piezoelektrischen Transformator (5) hin zur Öffnung (32) im Gehäuse (30) erzeugbar ist.

14. Handgerät (100) nach einem der Ansprüche 11 bis 13, **wobei** ein zusätzlicher Gasanschluss (102) vorgesehen ist, über den ein anderes Arbeitsgas als Luft dem zweiten freien Ende (8) des piezoelektrischen Transformators (5) zuführbar ist.

## Claims

1. A device (1) for generating a plasma (P) comprising a control circuit (3), which is electrically connected to a piezoelectric transformer (5) for the excitation thereof, a circuit board (7), on which the control circuit (3) is implemented, wherein the piezoelectric transformer (5) is mounted with a region (6B) of a first end (6) in relation to the circuit board (7), a high voltage can be generated at a second free end (8) of the piezoelectric transformer (5) and the plasma (P) can be ignited at atmospheric pressure, and a flow (15) of an operating gas in a housing (30), to form the plasma (P) and to cool the piezoelectric transformer (5), which flows via the control circuit (3) and the piezoelectric transformer (5) toward an opening (32) in the housing (30),
**characterized in that**
the piezoelectric transformer (5) is constructed from multiple layers (S₁, S₂,..., S_{N}) made of dielectric material, wherein the layers (S₁, S₂,..., S_{N}) are bonded to one another and wherein each layer (S₁, S₂,..., S_{N}) is at least partially provided with a conductor layer (27),
one electrical terminal pad (20) is attached on each of opposing lateral surfaces (10) and in a vibration node (14) of the piezoelectric transformer (5),
electrical terminals (12) lead from the circuit board (7) to the electrical terminal pads (20); and
a mount (25), which interacts with the terminal pads (20) in such a way that the piezoelectric transformer (5) is spaced apart with a gap (18) above the circuit board (7) in a region (6B) of the first end (6).

2. The device (1) according to Claim 1, wherein the piezoelectric transformer (5) is cuboid and a length (L) and a width (B) of the piezoelectric transformer (5) is greater than a thickness (D) of the piezoelectric transformer (5).

3. The device (1) according to Claim 1, wherein the mount (25) is made of an elastic material.

4. The device (1) according to any one of the preceding claims, wherein the flow (15) of the operating gas is formed in such a way that it is oriented at least from the first end (6) of the piezoelectric transformer (5) mounted above the circuit board (7) toward the second free end (8) of the piezoelectric transformer (5).

5. The device according to Claim 4, wherein a fan (17) is provided, which assists the flow (15) of the operating gas over the piezoelectric transformer (5) toward the second free end (8) of the piezoelectric transformer (5).

6. The device (1) according to any one of the preceding claims, wherein at least two vibration nodes (14), which are both spaced apart from the first end (6) or from the second free end (8), respectively, can be formed using a piezoelectric transformer (5) excited at a resonance frequency.

7. The device (1) according to Claim 6, wherein the vibration nodes (14) are located closer toward the first end (6) than toward the second end (8) of the piezoelectric transformer (5).

8. The device (1) according to Claim 1, wherein a temperature sensor (24) is associated with at least one vibration node (14) of the piezoelectric transformer (5).

9. The device (1) according to Claim 1, wherein the electrical terminal (12), the mount (25) for the piezoelectric transformer (5), and the mount (25) are made of a material which is elastic and electrically conductive.

10. The device (1) according to any one of the preceding claims, wherein the circuit board (7) and the piezoelectric transformer (5) form a structural unit.

11. A hand-held apparatus (100) for plasma treatment of surfaces, comprising a housing (30), a voltage source (50), and a circuit board (7) provided in the housing (30), having a control circuit (3) for exciting a piezoelectric transformer (5), wherein a first end (6) of the piezoelectric transformer (5) is associated with the circuit board (7) and a second free end (8) of the piezoelectric transformer (5) is oriented toward an opening (32) in the housing (30),
wherein a high voltage can be generated at the second free end (8) of the piezoelectric transformer (5) and the plasma (P) can be ignited at atmospheric pressure,
wherein a flow (15) of an operating gas for forming the plasma (P) and for cooling the piezoelectric transformer (5) flows over the control circuit (3) and the piezoelectric transformer (5);
**characterized in that**
the piezoelectric transformer (5) is constructed from multiple layers (S₁, S₂,..., S_{N}) made of dielectric material, wherein the layers (S₁, S₂,..., S_{N}) are bonded to one another and wherein each layer (S₁, S₂,..., S_{N}) is at least partially provided with a conductor layer (27),
one electrical terminal pad (20) is attached on each of opposing lateral surfaces (10) and in a vibration node (14) of the piezoelectric transformer (5),
electrical terminals (12) lead from the circuit board (7) to the electrical terminal pads (20); and
a mount (25), which interacts with the terminal pads (20) in such a way that the piezoelectric transformer (5) is spaced apart by a gap (18) freely above the circuit board (7) in a region (6B) of the first end (6), and the piezoelectric transformer (5) and the circuit board (7) form a structural unit.

12. The hand-held apparatus (100) according to Claim 11, wherein a temperature sensor (24) is associated with the at least one vibration node (14) of the piezoelectric transformer (5).

13. The hand-held apparatus (100) according to any one of Claims 11 to 12, wherein the housing (30) supports a fan (17), with which an airflow can be generated over the piezoelectric transformer (5) toward the opening (32) in the housing (30).

14. The hand-held apparatus (100) according to any one of Claims 11 to 13, wherein an additional gas fitting (102) is provided, via which an operating gas other than air can be supplied to the second free end (8) of the piezoelectric transformer (5).

## Revendications

1. Dispositif (1) pour la production d'un plasma (P) avec un circuit de commande (3) relié électriquement à un transformateur piézoélectrique (5) pour exciter celui-ci, une carte de circuits (7) sur laquelle le circuit de commande (3) est réalisé, dans lequel le transformateur piézoélectrique (5) est retenu par une zone (6b) d'une première extrémité (6) par rapport à la carte de circuits (7), une haute tension peut être générée à une deuxième extrémité libre (8) du transformateur piézoélectrique (5) et le plasma (P) peut être allumé à la pression atmosphérique, et dans lequel un flux (15) d'un gaz de travail circule dans un boîtier (30) par-dessus le circuit de commande (3) et le transformateur piézoélectrique (5) vers une ouverture (32) dans le boîtier (30) pour former le plasma (P) et refroidir le transformateur piézoélectrique (5),
**caractérisé en ce que**
le transformateur piézoélectrique (5) est composé de plusieurs couches (S₁, S₂... S_{N}) de matériau diélectrique, les couches (S₁, S₂... S_{N}) étant reliées entre elles et chaque couche (S₁, S₂... S_{N}) étant au moins en partie munie d'une couche conductrice (27) ;
une pastille de connexion électrique (20) est disposée sur chacune des surfaces latérales (10) opposées et dans un noeud oscillatoire (14) du transformateur piézoélectrique (5) ;
des connexions électriques (12) mènent de la carte de circuits (7) aux pastilles de connexion électriques (20) et
une monture (25) coopère avec les pastilles de connexion (20) de sorte que le transformateur piézoélectrique (5) est écarté à une distance (18) au-dessus de la carte de circuits (7) dans une zone (6b) de la première extrémité (6).

2. Dispositif (1) selon la revendication 1, dans lequel le transformateur piézoélectrique (5) est en forme de quadrilatère et la longueur (L) et la largeur (B) du transformateur piézoélectrique (5) sont plus grandes que l'épaisseur (D) du transformateur piézoélectrique (5).

3. Dispositif (1) selon la revendication 1, dans lequel la monture (25) est faite d'un matériau élastique.

4. Dispositif (1) selon l'une des revendications précédentes, dans lequel le flux (15) de gaz de travail est conformé de manière à être dirigé au moins de la première extrémité (6) du transformateur piézoélectrique (5) retenu au-dessus de la carte de circuits (7) vers la deuxième extrémité libre (8) du transformateur piézoélectrique (5).

5. Dispositif selon la revendication 4, dans lequel est prévu un ventilateur (17) qui soutient le flux (15) de gaz de travail par-dessus le transformateur piézoélectrique (5) vers la deuxième extrémité libre (8) du transformateur piézoélectrique (5).

6. Dispositif (1) selon l'une des revendications précédentes, dans lequel au moins deux noeuds oscillatoires (14) peuvent être formés dans un transformateur piézoélectrique (5) excité à une fréquence de résonance, tous deux à distance de la première extrémité (6) ou de la deuxième extrémité libre (8).

7. Dispositif (1) selon la revendication 6, dans lequel le noeud oscillatoire (14) se trouve plus près de la première extrémité (6) que de la deuxième extrémité libre (8) du transformateur piézoélectrique (5).

8. Dispositif (1) selon la revendication 1, dans lequel une sonde de température (24) est associée à au moins un noeud oscillatoire (14) du transformateur piézoélectrique (5).

9. Dispositif (1) selon la revendication 1, dans lequel la connexion électrique (12), la monture (25) pour le transformateur piézoélectrique (5) et la monture (25) sont faits d'un matériau élastique et conducteur électrique.

10. Dispositif (1) selon l'une des revendications précédentes, dans lequel la carte de circuits (7) et le transformateur piézoélectrique (5) forment une unité de construction.

11. Appareil manuel (100) pour le traitement par plasma de surfaces, avec un boîtier (30), une source de tension (50) et une carte de circuits (7) prévue dans le boîtier (30), avec un circuit de commande (3) pour exciter un transformateur piézoélectrique (5), le transformateur piézoélectrique (5) étant associé à une première extrémité (6) de la carte de circuits (7) et une deuxième extrémité libre (8) du transformateur piézoélectrique (5) étant orientée vers une ouverture (32) du boîtier (30),
dans lequel une haute tension peut être générée à la deuxième extrémité libre (8) du transformateur piézoélectrique (5) et le plasma (P) peut être allumé à la pression atmosphérique,
dans lequel un flux (15) d'un gaz de travail circule par-dessus le circuit de commande (3) et le transformateur piézoélectrique (5) pour la formation du plasma (P) et le refroidissement du transformateur piézoélectrique (5),
**caractérisé en ce que**
le transformateur piézoélectrique (5) est composé de plusieurs couches (S₁, S₂... S_{N}) de matériau diélectrique, les couches (S₁, S₂... S_{N}) étant reliées entre elles et chaque couche (S₁, S₂... S_{N}) étant au moins en partie munie d'une couche conductrice (27) ;
une pastille de connexion électrique (20) est disposée sur chacune des surfaces latérales (10) opposées et dans un noeud oscillatoire (14) du transformateur piézoélectrique (5) ;
des connexions électriques (12) mènent de la carte de circuits (7) aux pastilles de connexion électriques (20) ; et
une monture (25) coopère avec les pastilles de connexion (20) de sorte que le transformateur piézoélectrique (5) est libre et écarté à une distance (18) au-dessus de la carte de circuits (7) dans une zone (6b) de la première extrémité (6), et le transformateur piézoélectrique (5) et la carte de circuits (7) forment une unité de construction.

12. Appareil manuel (100) selon la revendication 11, dans lequel une sonde de température (24) est associée à l'au moins un noeud oscillatoire (14) du transformateur piézoélectrique (5).

13. Appareil manuel (100) selon l'une des revendications 11 à 12, dans lequel le boîtier (30) porte un ventilateur (17) qui peut produire un flux d'air passant par-dessus le transformateur piézoélectrique (5) vers l'ouverture (32) du boîtier (30).

14. Appareil manuel (100) selon l'une des revendications 11 à 13, dans lequel est prévu un raccord de gaz supplémentaire (102) par lequel un gaz de travail autre que de l'air peut être amené à la deuxième extrémité libre (8) du transformateur piézoélectrique (5).
